# EUROPEAN PATENT SPECIFICATION

(11) **EP 2 922 107 B1**
(45) Date of publication and mention of the grant of the patent: **03.05.2017**
(21) Application number: 14305375.9
(22) Date of filing: 18.03.2014
(51) Int. Cl.: H01L 41/113, H02N 2/18

(54) **Apparatus for harvesting energy**
Vorrichtung zur Energiegewinnung
Appareil de collecte d'énergie

(43) Date of publication of application: 23.09.2015
(73) Proprietor: ALCATEL LUCENT, 92100 Boulogne-Billancourt (FR)
(72) Inventor: Frizzell, Ronan, Blanchardstown, Dublin 15 (IE); Jeffers, Nicholas, Blanchardstown, Dublin 15 (IE); Kelly, Gerard, Blanchardstown, Dublin 15 (IE)
(74) Representative: Shamsaei Far, Hassan

(56) References cited:
- CN-A- 102 937 607
- US-A1- 2010 186 487

## Description

The present disclosure relates to a technique for harvesting energy.

### BACKGROUND

Vibration energy harvesting is typically the process of using vibrations from the environment to drive generators that provide power for use in electric/electronic devices. This technology has certain advantages as it is typically capable of providing power autonomy, at least to some extent, to electric systems that would otherwise have to rely solely on battery power. Battery powered systems typically require routine maintenance to replace the battery, which adds significant cost to the operator of the device. For example, in the case of wireless sensor nodes, the issue of power may become a major bottleneck to the wide deployment of large wireless sensor networks where it is typically needed that a high number of batteries be replaced routinely. Such battery replacements have costs associated with them which may hamper large-scale deployments of wireless sensor nodes that are useful for constructing the so-called "Smart" systems such as "Smart Buildings" and "Smart Cities".

US 2010/0186487 A1 relates to a cantilever-type sensor, a substance sensing system and a substance sensing method that use the sensor.

CN 102 937 607 A relates to a series-connection flexible vibration piezoelectric diaphragm type biosensor and preparation method thereof.

### SUMMARY

Some embodiments feature an energy harvester according to claim 1.

According to some specific embodiments, the support base structure is attached to the mass element by a spring.

According to some specific embodiments, the support base structure comprises a piezoelectric element attached to the mass element.

According to some specific embodiments, the mass element is comprised in a cantilever beam having a generally planar body anchored at one end to the support base and capable of oscillating at an opposite end in response to a driving force exerted thereon.

According to some specific embodiments, the mass element is comprised in a cantilever beam having a generally planar body anchored at two ends to respective support bases and capable of oscillating at an intermediate position between the two anchored ends in response to a driving force exerted thereon. According to some specific embodiments, at least some channels have a respective cross-sectional area between about 0.01 mm² and about 4 mm². According to some specific embodiments, a total volume of the channels within the mass element is less than about 90% of the total volume of the at least one portion of the mass element.

According to some specific embodiments, the apparatus further comprises a liquid input terminal and a liquid output terminal, and a valve configured to control the flow of the liquid.

Some embodiments feature an energy harvester comprising the apparatus as featured herein.

According to some specific embodiments, the energy harvester comprises a reservoir of liquid configured to supply liquid to the channels or receive liquid extracted from the channels.

According to some specific embodiments, the energy harvester comprises a pump configured to pump liquid into or out of the channels

According to some specific embodiments, the control unit is further configured to monitor a power generated by the energy harvester to ensure that a resonant frequency of the beam matches a frequency generated by a source of external mechanical disturbance.

According to some specific embodiments, the energy harvester further comprises a transducer configured to convert kinetic energy transferred to the mass element in response mechanical disturbance imposed on a housing of the energy harvester into electric energy.

According to some specific embodiments the transducer comprises a coil adapted to generate an electric current in response to receiving magnetic excitation caused by the movement of a magnet comprised in the mass element. According to some specific embodiments the transducer comprises a piezoelectric material configured to receive mechanical excitation as a result of the oscillation of the mass element and generate electric energy.

According to some specific embodiments the transducer comprises a magnetostrictive element in proximity of a coil and configured to receive mechanical excitation as a result of the oscillation of the mass element and generate a varying magnetic field capable of exciting the coil.

According to some specific embodiments the transducer comprises a magnetostrictive element attached to an electro-active material and configured to vary in shape in response to a varying magnetic field generated by a magnet provided in the mass element thereby causing generation of electric current in the electro-active material.

These and further features and advantages of the present invention are described in more detail, for the purpose of illustration and not limitation, in the following description as well as in the claims with the aid of the accompanying drawings.

### BRIEF DESCRIPTION OF THE DRAWINGS

Figure 1 is an exemplary perspective view of a cantilever beam structure which may be used in an energy harvester according to an embodiment of the disclosure.
Figure 2 is an exemplary schematic representation of elements of an energy harvester according to some embodiments of the disclosure.

### DETAILED DESCRIPTION

As it is known, devices that capture mechanical energy from the environment and convert it to useful form of energy are often referred to as "energy harvesters." Some known energy harvesters are based on oscillation concepts. One example of such known energy harvesters comprises a single movable mass element located inside a housing of the harvester. When the device is subjected to a mechanical disturbance (e.g. a vibration caused by a motor or an air conditioning system), forces are transferred from the housing to the mass element causing it to undergo a displacement. Typically such displacement may be in the form of an oscillation, or a vibration, having amplitude and frequency which may remain constant for a certain period of time or vary in time.

The oscillation of the moveable mass element is optimum, in terms of amplitude of oscillation, when the resonant frequency of the moveable mass element matches the frequency of oscillation of the mechanical disturbance. Furthermore, the resonant frequency of the moveable body depends directly on its mass, although other factors may also have an effect on the resonant frequency. By way of non-limiting example, in a mass-spring combination arrangement where a mass element is resiliently attached to a spring, which in turn is attached to a housing of the energy harvester, factors affecting the stiffness of the spring attaching the mass to the housing may have an effect on the resonant frequency. Likewise, in a cantilever beam structure as will be described further below, the rigidity of the material forming the body of the cantilever may have an effect on the resonant frequency.

Herein the terms oscillation and vibration are to be understood to have the same meaning as they relate to mechanical periodical movements of a physical body about a point of equilibrium.

Furthermore, the term moveable mass is to be understood to encompass a mass element which is moveable in its entirety, e.g. a body of mass positioned on a spring such that the entire body of the mass element oscillates when kinetic energy is transferred from the spring to the mass element; or a mass element which is anchored, and therefore fixed at one end or at two ends, and has a free end being capable of moving or a portion of the body thereof is capable of moving when kinetic energy is transferred from the fixed end, or ends, to the rest of the body of the mass element, e.g. a cantilever beam having an anchored end and a free end.

Known single-mass energy harvesters typically need to be tuned prior to deployment to produce usable power at a particular resonant frequency. However, the power they generate may diminish significantly as the driving frequency caused by the mechanical disturbance shifts away from the resonant frequency, giving the device what is typically known as a narrow bandwidth. In real-life applications driving frequencies do not always remain at a single frequency and may vary with time causing the power generated by the energy harvester to diminish, in occasions severely.

Some single-mass energy harvesters may include structures comprising a mass/spring combination in which the mass element is resiliently attached to the housing of the energy harvester by means of a spring. The kinetic energy transferred to the mass element as a result of mechanical disturbance imposed on the housing is converted into electric energy by using a transducer, e.g. a coil adapted to generate an electric current in response to variations in magnetic field density caused by the movement of a magnet included in the mass element. This structure of a single-mass energy harvester is known.

Some single-mass energy harvesters may include structures comprising a cantilever beam (or blade) which typically is a generally planar body anchored at one end to a support base and capable of oscillating at an opposite end in response to a driving force exerted thereon. In this configuration, the blade may be considered to be the mass element capable of oscillating when kinetic energy is transferred from the support base to the mass element as a result of mechanical disturbance imposed on the support bases (or a housing to which the support base may be attached). The mechanical displacement of the cantilever beam is then converted into electric energy by using a transducer.

Alternatively, cantilever beams used in some energy harvesters may be anchored at two ends of the cantilever beam such that the beam is capable of oscillating at an intermediate portion, e.g. near the longitudinal center of the beam structure, as opposed to oscillating at a free end thereof.

These energy harvester structures based on cantilever beams are also known. One example of transducer may be a coil adapted to generate an electric current in response to variations in magnetic field density caused by the movement of a magnet included in the movable mass element (the cantilever beam).

Another example of a transducer may be a piezoelectric material comprised in or near the support base and configured to undergo mechanical straining as a result of the oscillation of the cantilever beam and generate electric energy.

A further example of transducer may be a magnetostrictive element. A magnetostrictive element can be configured to receive mechanical excitation as a result of the oscillation of the mass element. This has the effect of varying the material's magnetic field which may be exposed onto a coil to thereby generate electric current. Furthermore, a magnetostrictive element also has the property of varying its shape when exposed to a changing magnetic field. This may be achieved if the mass element comprises a magnet such that when the magnet is is moving due to the oscillation of the mass element caused by the external mechanical excitation, the magnetic field lines corresponding to the magnet interact with the magnetostrictive element thereby causing changes in the shape of the latter. In this manner, if an electro-active material such as a piezoelectric element is attached to the magnetostrictive element the varying shape of the magnetostrictive element can be used to cause mechanical disturbance (e.g. compression, extension) on the the piezoelectric material, thereby causing generation of electric current.

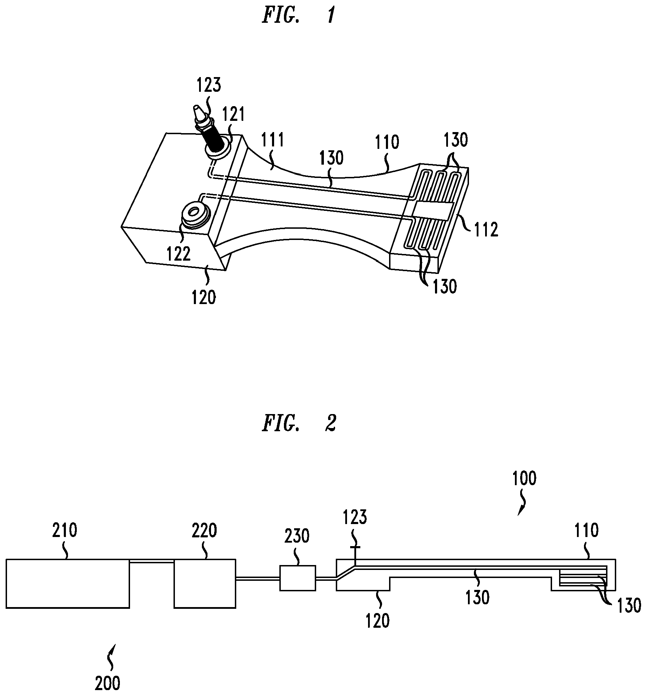

Electric current can also be generated using a coil to harness the varying magnetic field resulting from the moving magnet and its effect on the magnetostrictive material. The movement of the magnet would induce a change in shape of the magnetostrictive material, which would in turn result in a change of the magentic field around the magnetostrictive material. A coil may be affixed close to the magnetostrictive element and a current would be induced in the coil. Figure 1 illustrates a cantilever beam structure 100 which may be used in an energy harvester according to some embodiments of the disclosure. The cantilever beam structure 100 comprises a cantilever beam 110 which is anchored at one end 111 to a base structure 120 and has a free end 112 at an opposite end. The base structure 120 may be attached directly on an external body (not shown) which is capable of transferring external mechanical disturbance to the base structure 120, for example a post installed on a road to receive vibration caused by the movement of vehicles on the road. Alternatively the base structure 120 may be attached to a housing (not shown) which encloses the energy harvester and the housing may in turn be attached to an external body capable of transferring external mechanical disturbance to the base structure.

When external mechanical disturbance is transferred to the base structure 120, the latter in turn transfers such disturbance to the anchored end 111 of the cantilever beam 110. As a result the free end of the cantilever beam starts to oscillate out-of-phase with respect to the base structure 120. The oscillation of the free end 112 of the cantilever beam is a result of kinetic energy being transferred from the base structure to the cantilever beam and this can be converted into electric energy using a transducer, examples of which were provided above.

As the frequency of the source of mechanical disturbance approaches the resonant frequency of the cantilever beam 110, the out-of-phase displacement of the free end 112 thereof increases considerably and this causes the generated electric energy (i.e. the harvested power) to increase. If the frequency of the source of mechanical disturbance shifts away from the resonant frequency of the cantilever beam 110, the electric power generated by the energy harvester diminishes.

According to embodiments of the disclosure, channels 130 are provided in the structure of the of the cantilever beam 110. The channels 130 are hollow and may be configured to allow a liquid to move within their interior hollow space. By controlling the amount of the liquid which is present in the body of the cantilever beam 110, the mass of the cantilever can be adjusted. Therefore, in case the frequency of oscillation originated by the source of mechanical disturbance changes and does no longer match with the resonant frequency of the cantilever beam 110, by adjusting the amount of the liquid in the cantilever beam 110, it may be possible to change its resonant frequency such that the new resonant frequency matches the changed frequency of oscillation originated by the source of mechanical disturbance.

The liquid may be of any know type such as for example water, mercury, ferrofluids or a dielectric liquid. It is to be noted that the use of dielectric liquids may be advantageous as in the event of damage to the harvester and leak of the liquid, it does not conduct electricity between the surrounding electronic components.

As mentioned above, the resonant frequency of the cantilever beam 110 of the energy harvester 100 depends directly on the mass of the cantilever beam 110. Therefore, by providing more or less liquid into the cantilever beam, its mass can be varied, thereby varying the resonant frequency of the cantilever beam 110. Preferably the channels 130 may have cross-sections appropriately sized such that they do not adversely affect the structural integrity of the cantilever beam 110 and allow for a sustainable operation of the cantilever beam.

In some embodiments, one or more channels each have a respective cross-sectional area between about 0.01 mm² and about 4 mm². Channels made within this range may be advantageous as such a relatively reduced size may allow fine control over the amount of liquid that is to be moved and thus provide the possibility of an accurate control over the resonant frequency of the cantilever beam.

In some embodiments, a total volume of the channels within the mass element may be less than about 90% of the total volume of the portion of the mass element which is moveable (e.g. oscillates). This option may be advantageous in cases where it is desired to minimize pressure drop for the flow of the liquid within the channels.

Herein the term channel is to be understood broadly and irrespective of the size of the cross-section of the channel. Therefore, reference to a channel may also include a micro-channel as those generally referred to in the related art.

The channels may be embedded inside the body of the cantilever beam or they may be placed on a surface or sides thereof.

In order to facilitate the entrance and movement of the liquid within the channels 130, a liquid input terminal 121 and a liquid output terminal 122 may be provided in the energy harvester, for example at convenient locations on the base structure 120. A valve 123 may also be used to close or open the passage for the flow of the liquid and prevent liquid loss from the cantilever beam.

It may be appreciated that larger ranges for the change in resonant frequency may be achieved by increasing the number of channels and/or liquid density, thereby increasing the achievable change in mass. This means that the energy harvester according to the present disclosure can produce its maximum power over a broader range of frequencies compared to a solution without using the channels/liquid configuration.

Figure 2 schematically illustrates an exemplary energy harvester according to embodiments of the disclosure. In figure 2, like elements have been provided with like reference numerals as those of figure 1.

It is to be noted that for the sake of simplicity of illustration, only elements that are necessary for understanding the disclosure are shown in figure 2. For example a transducer for converting the kinetic or magnetic energy into electric energy is not shown in this figure. Those skilled in the related art will understand that various types of known transducers (e.g. piezoelectric, electromagnetic, magnetostrictive, or the like) may be used depending on the type of the conversion involved in each practical case and will know how to implement such transducers in the energy harvester of figure 2.

Referring now to figure 2, the energy harvester 200, comprises a cantilever beam structure 100, similar to the one described with reference to figure 1. The energy harvester 200 may further comprise a reservoir of liquid 210 configured to supply liquid to the channels 130 or receive liquid extracted from the channels 130 (e.g. when it is needed to decrease the mass of the cantilever beam 110).

A pump 220 may be provided in the energy harvester 200. The pump 220 may be located between the reservoir 210 and the cantilever beam structure 100 and may be configured to pump liquid into or out of the channels 130 as required. However the use of a pump is not mandatory as the liquid may be made to move by other knows means such as making use of the gravitational force.

The energy harvester may further comprise a control unit 230 configured for monitoring the mass of the cantilever beam 110 and to adjust it by varying the amount of liquid in the cantilever beam which has the effect of changing the resonant frequency of the harvester. The control unit 230 may further be configured to monitor the power being generated by the energy harvester 200 and use a control algorithm to ensure that the resonant frequency of the beam always matches the frequency generated by the source of external mechanical disturbance (i.e. maximum power is being harvested).

However the use of a control unit is not mandatory as the monitoring and adjustment operations may be made manually or by other known means. For example, the manual means may make use of a syringe to prime the system on a one-off basis when the device is first deployed.

Once the correct resonant frequency for the cantilever beam 110 is achieved the flow of the liquid thereto from the reservoir 210 may be blocked by using the valve 123 which would also prevent any liquid loss from the cantilever beam 110. For situations where active control is not required the energy harvester according to the present disclosure could also be used to accurately tune the resonant frequency of the energy harvester to a precise frequency by finely adjusting the amount of liquid, and hence the mass, of the cantilever beam prior to installation. This could be carried out in the field by filling the harvester as required and using the valve to seal the harvester once the required amount of liquid is transferred into the harvester.

The use of micro-channels is preferred and has certain advantages as already mentioned above. In addition, the use micro-channels has further advantages as it allows small amounts of liquid to be moved within the energy harvester which implies that the energy required to actively tune the harvester is relatively low. This may be an important consideration as in certain energy harvesting applications the power to tune devices must come from the harvested power and so it will be desirable that any active tuning system in the energy harvester has very low power requirements thereby allowing for a significant amount of net power to be harvested. In some embodiments, various energy harvesters may be used wherein some energy harvesters may provide power to the pump and some other energy harvesters may be used to generate net power for other devices. The use of micro-channels also offers the advantage of being versatile in the size, shape and distribution of the channels and is also scalable such that a network of micro-channels could be used to actively control a number of energy harvesters provided in an array where each individual energy harvester may receive liquid flowing in a common network of channels.

Although the embodiments of figures 1 and 2 were described with respect to a single mass energy harvester, the disclosure is not so limited and is likewise applicable to energy harvesters using multiple-mass configuration.

Furthermore, although the embodiments of figures 1 and 2 were described with respect to an energy harvester using a cantilever beam structure having a free end capable of oscillating in response to the external mechanical excitation transferred thereto, the disclosure is not so limited and is likewise applicable to other arrangements of energy harvesters using alternative configurations of linking mass elements to the device housing via resilient elements.

For example, in some embodiments the energy harvester may use a cantilever beam having two ends each anchored to a respective support base structure. In this arrangement, in case a mechanical disturbance is imposed on the energy harvester, the cantilever may oscillate at an intermediate portion of the body of the cantilever structure located between the two anchored ends.

In alternative configurations, a mass and a resilient element, e.g. a spring, may be used as previously described in relation to mass/spring combinations configured to oscillate in response to external mechanical disturbance as it is known in the art. However according the embodiments of the present disclosure, the mass element comprises channels which are configured to allow the passage of a liquid inside their hollow interior space. The liquid may be supplied to the channels in the mass element for example using flexible hoses.

It is to be noted that the list of structures corresponding to the claimed means is not exhaustive and that one skilled in the art understands that equivalent structures can be substituted for the recited structure without departing from the scope of the invention.

The control unit 230 may be any kind of device which can be programmed including e.g. any kind of computer like a server or a personal computer, an FPGA, a processor, or the like, or any combination thereof, e.g. one processor and two FPGAs.

The various embodiments of the present invention may be combined as long as such combination is compatible and/or complimentary.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

## Claims

1. An energy harvester (200) comprising:
- a support base structure (120);
- cantilever beam comprising a mass element (110) configured to oscillate out-of-phase at least at one portion thereof relative to the base structure (120) in response to a mechanical disturbance transferred from the support base structure to the mass element (110);
wherein the mass element comprises one or more channels (130) configured to selectively contain liquid to vary the mass of the mass element; **characterized in that** the energy harvester (200) further comprises a control unit (230) configured to monitor the mass of the mass element and to adjust said mass by varying the amount of liquid in the cantilever beam; and **in that** the mass element (110) is configured to oscillate at a first resonant frequency with a first channel being empty and oscillate at a second resonant frequency with the first channel containing liquid..

2. The energy harvester of claim 1, wherein the support base structure (120) is attached to the mass element (110) by a spring.

3. The energy harvester of claim 1 or claim 2, wherein the support base structure comprises a piezoelectric element attached to the mass element.

4. The energy harvester of any one of the preceding claims, wherein the cantilever beam has a generally planar body anchored at one end to the support base and is capable of oscillating at an opposite end in response to a driving force exerted thereon.

5. The energy harvester of any one of the preceding claims, wherein the cantilever beam has a generally planar body anchored at two ends to respective support bases and is capable of oscillating at an intermediate position between the two anchored ends in response to a driving force exerted thereon.

6. The energy harvester of any one of the preceding claims, wherein at least some channels have a respective cross-sectional area between about 0.01 mm² and about 4 mm².

7. The energy harvester of any one of the preceding claims, wherein a total volume of the channels within the mass element is less than about 90% of the total volume of the at least one portion of the mass element.

8. The energy harvester of any one of the preceding claims, further comprising a liquid input terminal (121) and a liquid output terminal (122), and a valve (123) configured to control the flow of the liquid.

9. The energy harvester of any one of the preceding claims, further comprising a reservoir (210) of liquid configured to supply liquid to the channels or receive liquid extracted from the channels.

10. The energy harvester of any one of the preceding claims, further comprising a pump (220) configured to pump liquid into or out of the channels.

11. The energy harvester of any one of the preceding claims, wherein the control unit (230) is further configured to monitor a power generated by the energy harvester to ensure that a resonant frequency of the beam matches a frequency generated by a source of external mechanical disturbance.

12. The energy harvester of any one of the preceding claims further comprising a transducer configured to convert kinetic energy transferred to the mass element in response mechanical disturbance imposed on a housing of the energy harvester into electric energy.

## Patentansprüche

1. Energy-Harvester (200), umfassend:
- eine tragende Grundstruktur (120);
- einen Auslegerarm, ein Masseelement (110) umfassend, das dafür konfiguriert ist, um in Reaktion auf eine mechanische Störung, die von der tragenden Grundstruktur an das Masseelement (110) übertragen wird, phasenverschoben an mindestens einem seiner Abschnitte im Verhältnis zur Grundstruktur (120) zu oszillieren;
wobei das Masseelement einen oder mehrere Kanäle (130) umfasst, konfiguriert für das selektive Enthalten von Flüssigkeit zur Veränderung der Masse des Masseelements; **dadurch gekennzeichnet, dass** der Energy-Harvester (200) weiterhin eine Steuereinheit (230) umfasst, die konfiguriert ist für das Überwachen der Masse des Masseelements und für das Anpassen besagter Masse durch Verändern der Flüssigkeitsmenge in dem Auslegerarm; und weiterhin **dadurch gekennzeichnet, dass** das Masseelement (110) dafür konfiguriert, um in einer ersten resonanten Frequenz mit einem ersten, leeren Kanal zu oszillieren sowie um in einer zweiten Resonanzfrequenz mit dem ersten, Flüssigkeit enthaltenden Kanal zu oszillieren.

2. Der Energy-Harvester nach Anspruch 1, wobei die tragende Grundstruktur (120) an dem Masseelement (110) mit einer Feder befestigt ist.

3. Der Energy-Harvester nach Anspruch 1 oder Anspruch 2, wobei die tragende Grundstruktur ein piezoelektrisches Element umfasst, welches an dem Masseelement befestigt ist.

4. Der Energy-Harvester nach jeglichem der vorgenannten Ansprüche, wobei der Auslegerarm einen im Allgemeinen flachen Körper hat, der mit einem seiner Enden an der tragenden Grundstruktur verankert und dafür ausgelegt ist, um am entgegengesetzten Ende in Reaktion auf eine auf ihn ausgeübte Antriebskraft zu oszillieren.

5. Der Energy-Harvester nach jeglichem der vorgenannten Ansprüche, wobei der Auslegerarm einen im Allgemeinen flachen Körper hat, der mit zwei Enden an jeweiligen tragenden Grundstrukturen verankert und dafür ausgelegt ist, um an einer mittleren Position zwischen den beiden verankerten Enden in Reaktion auf eine auf ihn ausgeübte Antriebskraft zu oszillieren.

6. Der Energy-Harvester nach jeglichem der vorgenannten Ansprüche, wobei mindestens einige Kanäle einen jeweiligen abschnittsübergreifenden Bereich zwischen 0,01 mm² und rund 4 mm² Größe haben.

7. Der Energy-Harvester nach einem jeglichen der vorgenannten Ansprüche, wobei ein Gesamtvolumen der Kanäle in dem Masseelement weniger als rund 90% des Gesamtvolumens des mindestens einen Anteils des Masseelements hat.

8. Der Energy-Harvester nach jeglichem der vorgenannten Ansprüche, weiterhin ein Flüssigkeitseingabeterminal (121) und ein Flüssigkeitsausgabeterminal (122) sowie ein Ventil (123) zur Steuerung des Flüssigkeitsstroms umfassend.

9. Der Energy-Harvester nach jeglichem der vorgenannten Ansprüche, weiterhin ein Reservoir (210) für Flüssigkeit umfassend, welches dafür konfiguriert ist, um Flüssigkeit in die Kanäle einzugeben oder Flüssigkeit aus den Kanälen aufzunehmen.

10. Der Energy-Harvester nach jeglichem der vorgenannten Ansprüche, weiterhin eine Pumpe (220) umfassend, welche dafür konfiguriert ist, um Flüssigkeit in die Kanäle hinein- oder aus ihnen herauszupumpen

11. Der Energy-Harvester nach jeglichem der vorgenannten Ansprüche, wobei die Steuereinheit (230) weiterhin konfiguriert ist für das Überwachen einer von dem Energy-Harvester generierten Energie, um zu gewährleisten, dass eine resonante Frequenz des Auslegerarms mit einer Frequenz übereinstimmt, die von einer externen mechanischen Störungsquelle generiert wird.

12. Der Energy-Harvester nach einem jeglichem der vorgenannten Ansprüche, weiterhin einen Transducer umfassend, der konfiguriert ist für das Konvertieren kinetischer Energie, die in Reaktion auf die auf ein Gehäuse des Energy-Harvesters einwirkende, mechanische Störung, auf das Masseelement übertragen wird, in elektrische Energie.

## Revendications

1. Récupérateur d'énergie (200) comprenant :
- une structure de base de support (120) ;
- une poutre en porte-à-faux comprenant un élément massique (110) configuré pour osciller sur une partie au moins de lui-même en déphasage par rapport à la structure de base (120) en réponse à une perturbation mécanique transmise de la structure de base de support à l'élément massique (110) ;
dans lequel l'élément massique comprend un ou plusieurs canaux (130) configurés pour contenir sélectivement du liquide afin de faire varier la masse de l'élément massique ;
**caractérisé en ce que** le récupérateur d'énergie (200) comprend en outre une unité de commande (230) configurée pour surveiller la masse de l'élément massique et pour ajuster ladite masse en faisant varier la quantité de liquide dans la poutre en porte-à-faux; et **en ce que** l'élément massique (110) est configuré pour osciller à une première fréquence de résonance lorsque le premier canal est vide et pour osciller à une deuxième fréquence de résonance lorsque le premier canal contient du liquide.

2. Récupérateur d'énergie selon la revendication 1, dans lequel la structure de base de support (120) est reliée à l'élément massique (110) par un ressort.

3. Récupérateur d'énergie selon la revendication 1 ou 2, dans lequel la structure de base de support comprend un élément piézoélectrique relié à l'élément massique.

4. Récupérateur d'énergie selon l'une quelconque des revendications précédentes, dans lequel la poutre en porte-à-faux a un corps généralement plan fixé à une extrémité à la base de support et peut osciller à l'extrémité opposée en réponse à une force d'entraînement qui s'exerce sur elle.

5. Récupérateur d'énergie selon l'une quelconque des revendications précédentes, dans lequel la poutre en porte-à-faux a un corps généralement plan fixé aux deux extrémités à des bases de support respectives et peut osciller dans une position intermédiaire entre les deux extrémités fixées en réponse à une force d'entraînement qui s'exerce sur elle.

6. Récupérateur d'énergie selon l'une quelconque des revendications précédentes, dans lequel certains canaux au moins ont une section transversale respective valant entre environ 0,01 mm² et environ 4 mm².

7. Récupérateur d'énergie selon l'une quelconque des revendications précédentes, dans lequel le volume total des canaux dans l'élément massique est inférieur à environ 90 % du volume total d'au moins une partie de l'élément massique.

8. Récupérateur d'énergie selon l'une quelconque des revendications précédentes, comprenant en outre un raccord d'entrée de liquide (121) et un raccord de sortie de liquide (122), et une vanne (123) configurée pour contrôler la circulation du liquide.

9. Récupérateur d'énergie selon l'une quelconque des revendications précédentes, comprenant en outre un réservoir (210) de liquide configuré pour alimenter en liquide les canaux ou recevoir du liquide extrait des canaux.

10. Récupérateur d'énergie selon l'une quelconque des revendications précédentes, comprenant en outre une pompe (220) configurée pour pomper le liquide dans les ou hors des canaux.

11. Récupérateur d'énergie selon l'une quelconque des revendications précédentes, dans lequel l'unité de commande (230) est en outre configurée pour surveiller la puissance générée par le récupérateur d'énergie afin de garantir qu'une fréquence de résonance de la poutre correspond à une fréquence générée par une source de perturbation mécanique externe.

12. Récupérateur d'énergie selon l'une quelconque des revendications précédentes, comprenant en outre un transducteur configuré pour convertir en énergie électrique l'énergie cinétique transférée à l'élément massique en réponse à une perturbation mécanique appliquée au boîtier du récupérateur d'énergie.
